Europäisches Patentamt

European Patent Office

Office européen des brevets

(11) Publication number: **0 093 803**
**A2**

(12) **EUROPEAN PATENT APPLICATION**

(21) Application number: **82112039.1**

(22) Date of filing: **27.12.82**

(51) Int. Cl.³: **G 01 D 7/04**, G 01 R 13/02

(30) Priority: **16.04.82 JP 62438/81**

(43) Date of publication of application: **16.11.83**
**Bulletin 83/46**

(84) Designated Contracting States: **DE FR GB IT**

(71) Applicant: **Hitachi, Ltd., 5-1, Marunouchi 1-chome, Chiyoda-ku Tokyo 100 (JP)**

(72) Inventor: **Sato, Tetsuo, 210-12, Shimosano-cho, Takasaki-shi Gumma (JP)**

(74) Representative: **Patentanwälte Beetz sen. - Beetz jun. Timpe - Siegfried - Schmitt-Fumian, Steinsdorfstrasse 10, D-8000 München 22 (DE)**

(54) **Indicating system.**

(57) An indicating system is constructed of first and second voltage comparators (10, 13), first and second output circuits (12, 15) which are respectively supplied with output signals of the first and second voltage comparators, and first and second indicating elements (21, 22) which are connected to a common output terminal of the first and second output circuits.

A first input terminal of the first voltage comparator is supplied with a first reference voltage ($V_1$), and a second input terminal thereof is supplied with a control signal ($V_{CONT}$). A first input terminal of the second voltage comparator is supplied with a second reference voltage ($V_2$), and a second input terminal thereof is supplied with the control signal ($V_{CONT}$).

When the voltage level of the control signal ($V_{CONT}$) is higher than the first reference voltage ($V_1$), the first output circuit (12) causes a current of a first polarity to flow to the common output terminal. As a result, the first indicating element (21) is lit up, and the second indicating element (22) is put out.

When the voltage level of the control signal ($V_{CONT}$) is lower than the second reference voltage ($V_2$), the second output circuit (15) causes a current of a second polarity to flow to the common output terminal. As a result, the first indicating element (21) is put out, and the second indicating element (22) is lit up.

When the voltage level of the control signal ($V_{CONT}$) is intermediate between the first and second reference voltages ($V_1$, $V_2$) the first and second indicating elements (21, 22) are put out.

# TITLE OF THE INVENTION

Indicating system

# BACKGROUND OF THE INVENTION

The present invention relates to an indicating system for use in indicating the operating statuses of various electronic equipment.

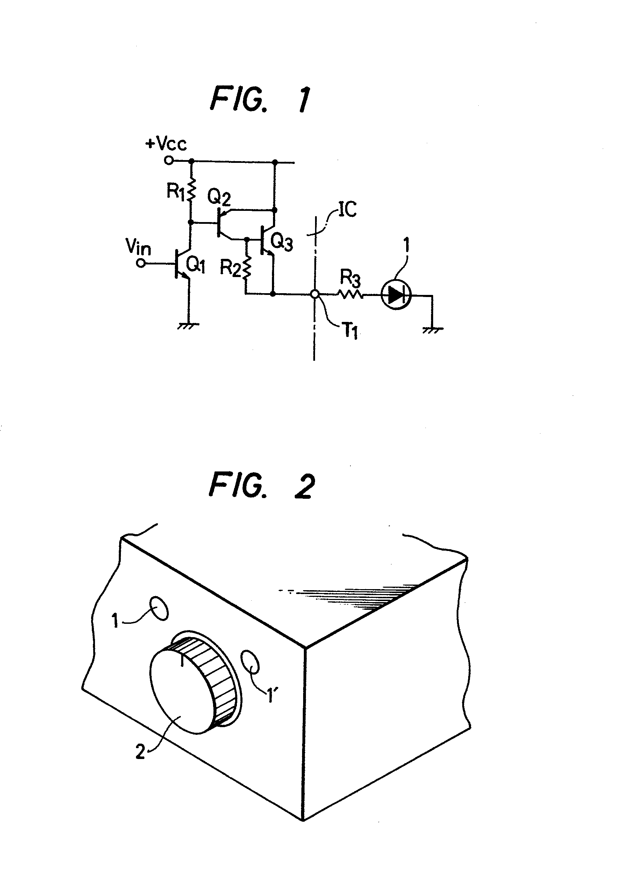

In audio equipment etc., indicating lamps are used, not only for the indication of the closure of a power supply, but also for, e. g., the tuning indication during the reception of a radio broadcast, indication during the play of a record, and the indication of various modes in a tape recorder. In this regard, each of circuit arrangements constituting the electronic equipment as mentioned above is, for the most part, fabricated in the form of a semiconductor integrated circuit. It is therefore desirable that an indicating driver circuit is also put into a semiconductor integrated circuit as shown in Figure 1 and constructed on an identical chip along with an amplifier etc.

The indicating driver circuit in the form of the semiconductor integrated circuit illustrated in Figure 1 was studied by the inventor prior to the invention of the present application. When the base of an NPN transistor $Q_1$ is supplied with a lighting signal $V_{in}$, this transistor $Q_1$ turns into the "on" state. Then, a voltage drop develops across a load resistor $R_1$, so that a PNP transistor $Q_2$ is supplied with a base voltage $V_{BE2}$ and is turned into the "on" state. As a result, current flows along a path which consists of a $+V_{CC}$ voltage source, the transistor $Q_2$, a bias resistor $R_2$, an output terminal $T_1$, a resistor $R_3$, a light emitting diode 1 and an earth line. In consequence, a voltage drop develops across the bias resistor $R_2$, and it supplies a base voltage $V_{BE3}$ to a transistor $Q_3$. The transistor $Q_3$ is turned into the "on" state, and a driving current flows along a path consisting of the $+V_{CC}$ voltage source, transistor $Q_3$, output terminal $T_1$, resistor $R_3$, light emitting diode 1 and earth line, so that the light emitting diode 1 is lit up.

With the circuit arrangement as described above, however, one external connection terminal, namely, output terminal $T_1$ is required for lighting up each light emitting diode 1. Accordingly, in a case where different modes are selected by turning a knob 2 counterclockwise and clockwise as illustrated in Figure 2, two indicating driver circuits must be disposed in order to light up two light emitting diodes 1 and 1'. This signifies the necessity of disposing two external connection terminals to the end of lighting up the two indicating lamps, and forms a factor of increase in cost in the case of fabricating the semiconductor integrated circuit. Moreover, with the prior-art circuit arrangement, even when the two indicating driver circuits are disposed, they can indicate only the two modes of one in which the first indicating lamp is lit up and the other in which the second indicating lamp is lit up. That is, in the presence of a plurality of modes to be selected, indicating lamp-lighting circuits must be disposed in agreement with the number of the modes, which is very inconvenient.

SUMMARY OF THE INVENTION

It is therefore an object of the present invention to provide an indicating system in which indicating lamps and driver circuits are connected by a single external connection terminal and which can indicate a plurality of modes.

BRIEF DESCRIPTION OF THE DRAWINGS

Figure 1 is a circuit diagram showing an example of an indicating driver circuit which was studied by the inventor prior to the invention of the present application;

Figure 2 is a perspective view of the pertinent portions of an electronic apparatus, showing an example of use of an indicating system;

Figure 3 is a circuit diagram of an indicating system, showing an embodiment of the present invention;

Figure 4 is a circuit diagram of an indicating circuit which can adjust brightness; and

Figure 5 is a circuit diagram of an indicating circuit, showing an example in the case where light emitting elements other than light emitting diodes are used.

## DESCRIPTION OF THE PREFERRED EMBODIMENTS

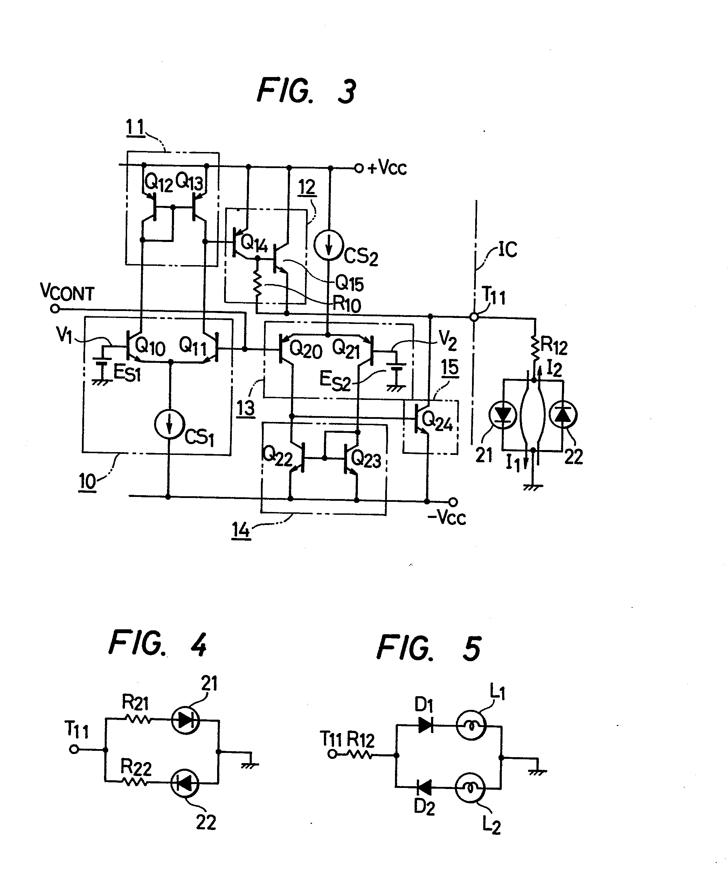

Referring now to Figure 3, an embodiment of an indicating system to which the present invention is applied will be described.

The system is constructed in the form of a semiconductor integrated circuit as denoted by IC in Figure 3.

More specifically, a first voltage comparator 10, a first load circuit 11, a first output circuit 12, a second voltage comparator 13, a second load circuit 14 and a second output circuit 15 are formed within the monolithic semiconductor integrated circuit (IC). On the other hand, two indicating lamps 21 and 22 which are alternately lit up in correspondence with the polarity change of a supply current are disposed outside the IC and are connected to the common output terminal $T_{11}$ of the IC through an external resistor $R_{12}$. The ends of the two indicating lamps 21 and 22 remote from the external resistor $R_{12}$ are connected to the earth potential.

NPN transistors $Q_{10}$ and $Q_{11}$ constitute the first voltage comparator 10 in the present invention. PNP

transistors $Q_{12}$ and $Q_{13}$ constitute a current mirror circuit, which operates as the load circuit 11 of the first voltage comparator 10. A PNP transistor $Q_{14}$ and an NPN transistor $Q_{15}$ constitute the first output circuit 12 in the present invention.

PNP transistors $Q_{20}$ and $Q_{21}$ constitute the second voltage comparator 13 in the present invention. NPN transistors $Q_{22}$ and $Q_{23}$ constitute a current mirror circuit, which operates as the load circuit 14 of the second voltage comparator 13. An NPN transistor $Q_{24}$ constitutes the second output circuit 15 in the present invention.

Bias voltage sources $E_{S1}$ and $E_{S2}$ different from each other are respectively connected to the base of the transistor $Q_{10}$ and that of the transistor $Q_{21}$. Letting $V_1$ denote the reference voltage of the source $E_{S1}$ and $V_2$ the reference voltage of the source $E_{S2}$, both are held in the relation of $V_1 > V_2$. The bases of the transistors $Q_{11}$ and $Q_{20}$ are supplied with a control signal $V_{CONT}$ in common. The voltage level of the control signal $V_{CONT}$ can change in the three stages of $V_{CONT} > V_1 > V_2$, $V_1 > V_{CONT} > V_2$ and $V_1 > V_2 > V_{CONT}$.

There will now be described circuit operations in the case where the voltage levels of the control signal $V_{CONT}$ and the bias voltage sources $E_{S1}$, $E_{S2}$ are

$$V_{CONT} > V_1 > V_2.$$

In this case, the transistor $Q_{11}$ turns into the "on" state, and the transistor $Q_{10}$ is in the "off" state. Accordingly, no current flows through the transistor $Q_{12}$. Current flows from a $+V_{CC}$ voltage source to an earth line via the emitter-base path of the transistor $Q_{14}$ and further the transistor $Q_{11}$ as well as a constant current circuit $CS_1$. Then, the transistor $Q_{14}$ turns into the "on" state, so that current flows through a resistor $R_{10}$ to supply the transistor $Q_{15}$ with a bias voltage. Therefore, current $I_1$ flows along a path consisting of the $+V_{CC}$ voltage source, transistor $Q_{15}$, output terminal $T_{11}$, resistor $R_{12}$, light emitting diode 21 and earth potential, and the light emitting diode 21 is lit up.

Here, the second voltage comparator 13 will be referred to. Since the transistors $Q_{20}$ and $Q_{21}$ are of the PNP type and the present condition is $V_{CONT} > V_1 > V_2$, the transistor $Q_{21}$ turns into the "on" state. Accordingly, current flows along a path consisting of the $+V_{CC}$ voltage source, a constant current circuit $CS_2$, the transistor $Q_{21}$, the transistor $Q_{23}$ and the $-V_{CC}$ voltage source. However the transistor $Q_{20}$ is in the "off" state, so that the transistor $Q_{24}$ is supplied with no bias voltage and is held in the "off" state.

That is, in the case of $V_{CONT} > V_1 > V_2$, the first

driver circuit 12 operates, the forward current $I_1$ flows through the light emitting diode 21, and only this light emitting diode 21 is lit up.

In other words, in the case of $V_{CONT} > V_1 > V_2$, the first load circuit 11 and the first output circuit 12 supply the current $I_1$ of the first polarity for lighting up the first light emitting diode 21, to the two parallel inverse connected diodes 21 and 22 in response to the output signal of the first voltage comparator 10, whereas the second load circuit 14 and the second output circuit 15 do not supply current $I_2$ of the second polarity for lighting up the second light emitting diode 22, to the parallel inverse connection in response to the output signal of the second voltage comparator 13.

In the next place, circuit operations in the case of $V_1 > V_{CONT} > V_2$ will be described.

In this case, the transistor $Q_{10}$ turns into the "on" state, and the transistor $Q_{11}$ is in the "off" state. Current flows along a path consisting of the $+V_{CC}$ voltage source, transistor $Q_{12}$, transistor $Q_{10}$, constant current circuit $CS_1$ and $-V_{CC}$ voltage source. As a result, the emitter-collector voltage $V_{CE}$ of the transistor $Q_{13}$ becomes substantially null, and the collector voltage thereof rises so as to approximate the voltage level of the $+V_{CC}$ voltage source. This voltage change signifies that the base potential of the transistor $Q_{14}$ approximates the emitter potential thereof, and the transistor $Q_{14}$ turns into the "off" state. Also the transistor $Q_{15}$ turns into the "off" state. Accordingly, the current $I_1$ having flowed from the $+V_{CC}$ voltage source to the light emitting diode 21 via the first output circuit 12 is cut off. The light emitting diode 21 is switched from the lit state into the extinguished state.

Here, the second voltage comparator 13 will be referred to. Owing to the condition of $V_{CONT} > V_2$, the base voltages of the transistors $Q_{20}$ and $Q_{21}$ do not basically differ from those in the case of $V_{CONT} > V_1 > V_2$. Accordingly, the second voltage comparator 13, second current mirror circuit 14 and second output circuit 15 do not operate.

That is, in the case of $V_1 > V_{CONT} > V_2$, no current flows through the light emitting diode 21 or 22, and neither is lit up.

In other words, in the case of $V_1 > V_{CONT} > V_2$, the first load circuit 11 as well as the first output circuit 12 and the second load circuit 14 as well as the second output circuit 15 stop the supply of the two currents $I_1$ and $I_2$ in response to the output signal of the first voltage comparator 10 and the output signal of the second voltage comparator 13, respectively.

Next, circuit operations in the case of $V_1 > V_2 > V_{CONT}$ will be described.

In this case, the respective circuit operations of the first voltage comparator 10, first current mirror circuit 11 and first output circuit 12 are similar to those in the case of the condition of $V_1 > V_{CONT} > V_2$.

When the second voltage comparator 13 is referred to, the transistor $Q_{20}$ turns into the "on" state. Since, however, the transistor $Q_{21}$ is in the "off" state, no current flows through the transistor $Q_{23}$. For this reason, the transistor $Q_{22}$ is in the "off" state. Accordingly, current flowing along the $+V_{CC}$ voltage source, constant current circuit $CS_2$ and transistor $Q_{20}$ flows to the $-V_{CC}$ voltage source through the base and emitter of the transistor $Q_{24}$. Thus, the transistor $Q_{24}$ is supplied with a base current and tends to turn into the "on" state.

As a result, the current $I_2$ flows along a current path which consists of the earth line, light emitting diode 22, resistor $R_{12}$, output terminal $T_{11}$, transistor $Q_{24}$ and the $-V_{CC}$ voltage source. The light emitting diode 22 is lit up, whereas the other light emitting diode 21 is not lit up.

In other words, in the case of $V_1 > V_2 > V_{CONT}$, the first load circuit 11 and the first output circuit 12 stop the supply of the current $I_1$ of the first polarity to the parallel inverse connection in response to the output signal of the first voltage comparator 10, whereas the second load circuit 14 and the second output circuit 15 execute the supply of the current $I_2$ of the second polarity to the parallel inverse connection in response to the output signal of the second voltage comparator 13.

As described above, the three sorts of indication; the indication in which only the light emitting diode 21 is lit up, the indication in which neither the light emitting diode 21 nor 22 is lit up, and the indication in which only the light emitting diode 22 is lit up, are effected by switching the voltage level of the control signal $V_{CONT}$ in the three stages.

The foregoing indicating operations are performed in such a way that the directions of the currents to flow through the respective light emitting diodes 21 and 22 are changed by utilizing the rectification characteristics of these light emitting diodes. As regards the light emitting diodes 21 and 22, accordingly, a modification to be described below is possible. The light emitting diodes 21 and 22 sometimes differ in brightness, depending upon a color to be emitted. In this case, resistors $R_{21}$ and $R_{22}$ for adjusting currents are individually disposed as shown in Figure 4. The quantity of current is decreased for the light emitting diode which is bright and prominent, and a larger quantity of current is caused to flow through the light emitting diode which is felt dark. Thus, the light rays to be emitted from the light emitting diodes 21 and 22 can be adjusted at will, and the degrees of brightness can be brought into agreement.

Although, in the foregoing embodiments, the light emitting diodes are used as light emitting elements, they are not restrictive. By way of example, a diode $D_1$ and an indicating lamp $L_1$, and a diode $D_2$ and an indicating lamp $L_2$ may be connected in series as shown in Figure 5. With this measure, the indicating lamps $L_1$ and $L_2$ can be selectively lit up owing to the current characteristics of the diodes $D_1$ and $D_2$.

As set forth above, according to the present invention, the voltage level of a control signal is changed in three stages, whereby a first indicating lamp and a second indicating lamp can be selectively lit up, and also, both can be put out, so that three sorts of modes corresponding to the voltage levels of the control signal can be indicated. Moreover, the lighting-up and putting-out of the indicating lamps are effected through a single common output terminal, so that production cost can be sharply curtailed in case of fabricating the indicating system in the form of a semiconductor integrated circuit.

What is claimed is:

1.  An indicating system comprising:

(a) a first voltage comparator (10) whose first input terminal is supplied with a first reference voltage ($V_1$) and whose second input terminal is supplied with a control signal ($V_{CONT}$);

(b) a second voltage comparator (13) whose first input terminal is supplied with a second reference voltage ($V_2$) and whose second input terminal is supplied with the control signal ($V_{CONT}$);

(c) a first output circuit (12) whose input terminal is connected to an output terminal of said first voltage comparator and which causes current of a first polarity ($I_1$) to flow to a common output terminal ($T_{11}$) when a voltage level of the control signal is higher than the first reference voltage;

(d) a second output circuit (15) whose input terminal is connected to an output terminal of said second voltage comparator and which causes current of a second polarity ($I_2$) to flow to said common output terminal ($T_{11}$) when the voltage level of the control signal is lower than the second reference voltage;

(e) a first indicating element (21) whose one end is connected to said common output terminal and which has its electrical characteristic determined so as to allow the current of the first polarity ($I_1$) to flow therethrough and to prevent the current of the second polarity ($I_2$) from flowing therethrough; and

(f) a second indicating element (22) whose one end is connected to said common output terminal and which has its electrical characteristic determined so as to allow the current of the second polarity ($I_2$) to flow therethrough and to prevent the current of the first polarity ($I_1$) from flowing therethrough.

2. An indicating system according to claim 1, wherein the first reference voltage ($V_1$) is higher in level than the second reference voltage ($V_2$).

3. An indicating system according to claim 2, wherein said first output circuit (12) and said second output circuit (15) are connected in series between a positive supply voltage ($+V_{CC}$) and a negative supply voltage ($-V_{CC}$), and the other ends of said first and second indicating elements (21, 22) are connected to an earth potential.

4. An indicating system according to claim 3, further comprising:

(g) a first load (11) which is connected between said output terminal of said first voltage comparator (10) and said positive supply voltage ($+V_{CC}$); and

(h) a second load (14) which is connected between said output terminal of said second voltage comparator (13) and said negative supply voltage ($-V_{CC}$).

5. An indicating system according to claim 4, wherein said first voltage comparator (10) includes a pair of differential NPN transistors ($Q_{10}$, $Q_{11}$), said second voltage comparator (13) includes a pair of differential PNP transistors ($Q_{20}$, $Q_{21}$), said first output circuit (12) includes a PNP transistor ($Q_{14}$) which has its emitter connected to said positive supply voltage ($+V_{CC}$), its base to said first load (11) and its collector to said common output terminal ($T_{11}$), and said second output circuit (15) includes an NPN transistor ($Q_{24}$) which has its emitter connected to said negative supply voltage ($-V_{CC}$), its base to said second load (14) and its collector to said common output terminal.

6. An indicating system according to claim 5, wherein said first indicating element is a first light emitting diode (21), while said second indicating element is a second light emitting diode (22), and these light emitting diodes (21, 22) are connected in a parallel inverse relationship.

7. An indicating system according to any of claims 1 to 5, wherein said first and second voltage comparators (10, 13) and said first and second output circuits (12, 15) are formed within a monolithic semiconductor integrated circuit, and said first and second indicating elements (21, 22) are disposed outside said monolithic semiconductor integrated circuit.

## FIG. 1

## FIG. 2

## FIG. 3

## FIG. 4

## FIG. 5